# EUROPEAN PATENT APPLICATION

(11) **EP 4 618 452 A1**
(43) Date of publication of application: **17.09.2025**
(21) Application number: 25163832.6
(22) Date of filing: 14.03.2025
(51) Int. Cl.: H04J 3/06, H03L 7/00, H04L 7/00, H04L 7/033, H04L 25/14, H03L 7/197, H04B 1/38

(54) **PPM FREQUENCY ERROR TRACKING WITH LANE-STATUS MONITORING SYSTEM FOR MULTI-LANE DIRECT-DETECT TRANSCEIVERS**

(30) Priority: 14.03.2024 US 202463565353 P; 13.03.2025 US 202519079252
(71) Applicant: Cisco Technology, Inc., San Jose, CA 95134 (US)
(72) Inventor: BHAT, Abhishek, San Jose, 95134 (US); TIAO, Jenjen, Allentown (US); ARRA, Sai Suhas, Allentown (US); NANDWANA, Romesh Kumar, CARLSBAD (US); SUNDER, Sanjay, Allentown (US)
(74) Representative: Thomas, Tomos Daniel

(57) **Abstract**

Frequency error tracking and lane monitoring techniques for multi-lane optical transceivers are provided. In one aspect, a method includes capturing phase and frequency information recovered by clock-and-data recovery circuits from data traveling along a plurality of lanes of an optical transceiver, with one of the lanes being a master lane; determining a frequency error based on the phase and frequency information of the master lane; outputting, by a tunable oscillator, a reference clock based on the frequency error; and controlling the optical transceiver based on i) a transmitter clock signal generated by a transmitter phase-locked loop (PLL) using the reference clock signal, and ii) a receiver clock signal generated by a receiver PLL using the reference clock signal.

## Description

### CROSS-REFERENCE TO RELATED APPLICATIONS

This application claims benefit of co-pending United States provisional patent application Serial No. 63/565,353 filed March 14, 2024. The aforementioned related patent application is herein incorporated by reference in its entirety.

### TECHNICAL FIELD

Embodiments presented in this disclosure generally relate to frequency error tracking and lane monitoring techniques for multi-lane optical transceivers.

### BACKGROUND

Demand for 800G electro-optical transceivers is increasing due to higher data rate requirements for the next-generation AI/ML applications running in data centers, cloud, and enterprise networks. In general, any 8x100G transceiver should be able to operate as an Nx100G transceiver, where N is between 1 and 8. Ideally, the transceiver should be able to change its configuration on the fly without affecting the active channels and the active channels' parts-per-million (PPM) frequency information should be successfully transferred to output without or with negligible errors. Typically, independent PPM tracking is done using multiple on-chip phase interpolators or phase locked loops (PLLs) which provides seamless lane-switching capability with independent PI's/PLL per lane but increases silicon area and power consumption.

### BRIEF DESCRIPTION OF THE DRAWINGS

So that the manner in which the above-recited features of the present disclosure can be understood in detail, a more particular description of the disclosure, briefly summarized above, may be had by reference to embodiments, some of which are illustrated in the appended drawings. It is to be noted, however, that the appended drawings illustrate typical embodiments and are therefore not to be considered limiting; other equally effective embodiments are contemplated.
FIG. 1A is a schematic diagram of an optical module according to one or more aspects of the present disclosure.
FIG. 1B is a schematic block diagram of features of the multi-lane optical transceiver of the optical module of FIG. 1A.
FIG. 1C is a schematic block diagram of features that can be implemented in the multi-lane optical transceiver of the optical module of FIG. 1A.
FIG. 1D is a schematic block diagram of features that can be implemented in the multi-lane optical transceiver of the optical module of FIG. 1A.
FIGS. 2A, 2B, and 2C provide a flow diagram for a method of frequency error tracking and lane monitoring for a multi-lane direct detect optical transceiver, according to one or more aspects of the present disclosure.
FIG. 3A shows a graph depicting phase error accumulation in an optical transceiver implementing the method of FIGS. 2A, 2B, 2C.
FIG. 3B shows a graph depicting phase error accumulation in an optical transceiver without implementing the method of FIGS. 2A, 2B, 2C.
FIG. 4 is a flow diagram for a method according to one or more aspects of the present disclosure.
FIG. 5 is a block diagram of a computing system according to one or more aspects of the present disclosure.

To facilitate understanding, identical reference numerals have been used, where possible, to designate identical elements that are common to the figures. It is contemplated that elements disclosed in one embodiment may be beneficially used in other embodiments without specific recitation.

### DESCRIPTION OF EXAMPLE EMBODIMENTS

### OVERVIEW

In one aspect, a method is provided. The method includes capturing phase interpolator (PI) control words and frequency control words recovered by clock-and-data recovery circuits from data traveling along each of a plurality of lanes of an optical transceiver, with one of the plurality of lanes being assigned as a master lane; determining a frequency error using a coarse error determined based on the frequency control word traveling along the master lane and a fine error determined based on the PI control word traveling along the master lane; outputting, by a tunable oscillator, a reference clock signal based at least in part on the frequency error; and controlling the optical transceiver based at least in part on i) a transmitter clock signal generated by a transmitter phase-locked loop using the reference clock signal, and ii) a receiver clock signal generated by a receiver phase-locked loop using the reference clock signal.

In another aspect, an optical transceiver is provided. The optical transceiver includes a plurality of receivers each having a clock and data recovery (CDR) circuit; a plurality of optical drivers coupled with the receivers via respective ones of a plurality of lanes; a receiver phase-locked loop; a transmitter phase-locked loop; a tunable oscillator; and a processor arranged to execute firmware to perform an operation. The operation includes: receiving phase interpolator (PI) control words recovered by the CDR circuits from data traveling along each lane of the plurality of lanes, with one of the plurality of lanes being assigned as a master lane; capturing frequency control words recovered by the CDR circuits from the data traveling along each lane of the plurality of lanes; and determining a frequency error using a coarse error determined based on the frequency control word traveling along the master lane and a fine error determined based on the PI control word traveling along the master lane. The tunable oscillator is arranged to output a reference clock signal based at least in part on the frequency error, and wherein the optical transceiver is controllable based at least in part on i) a transmitter clock signal generated by a transmitter phase-locked loop using the reference clock signal, and ii) a receiver clock signal generated by a receiver phase-locked loop using the reference clock signal.

In yet another aspect, an optical transceiver is provided. The optical transceiver includes a plurality of receivers each having a clock and data recovery (CDR) circuit; a plurality of optical drivers coupled with the receivers via respective ones of a plurality of lanes; a fractional receiver phase-locked loop; a fractional transmitter phase-locked loop; and a processor arranged to execute firmware to perform an operation. The operation includes: receiving phase interpolator (PI) control words recovered by the CDR circuits from data traveling along each of the plurality of lanes, with one of the plurality of lanes being assigned as a master lane; capturing frequency control words recovered by the CDR circuits from the data traveling along each of the plurality of lanes; determining a frequency error using a coarse error determined based on the frequency control word traveling along the master lane and a fine error determined based on the PI control word traveling along the master lane; and generating a fractional control word based at least in part on the frequency error. The optical transceiver is controllable based at least in part on i) a transmitter clock signal generated by the fractional transmitter phase-locked loop using the fractional control word, and ii) a receiver clock signal generated by the fractional receiver phase-locked loop using the fractional control word.

### EXAMPLE EMBODIMENTS

The present disclosure provides techniques for frequency error tracking and lane monitoring for multi-lane optical transceivers. The techniques disclosed herein can be implemented to track frequency errors and to monitor a plurality of lanes in a transmitter path of a multi-lane optical transceiver, e.g., by executing a firmware-based feedback loop and using an external tunable oscillator.

In at least one example, frequency and phase error information recovered by clock and data recovery (CDR) circuits from data traveling along a plurality of lanes of a multi-lane optical transceiver can be captured. Each lane can have an associated CDR circuit. One of the lanes can be assigned as a master lane, while the other lanes can be designated as non-master lanes. The frequency error information associated with the master lane can be used for initial settling of the feedback loop, e.g., to set the frequency error to ±0.5 parts-per-million (PPM). Indeed, the frequency error information associated with the master lane can be used to determine a coarse error associated with the data. The phase error information associated with the master lane can be used to determine a fine error associated with the data. The coarse error and the fine error can be used to determine a frequency error, which can be accumulated, scaled, and then routed to the tunable oscillator. The tunable oscillator can be dynamically tuned according to the accumulated and scaled frequency error, and can output a reference clock signal accordingly. The reference clock can be provided to a receiver phase-locked loop and to a transmitter phase-locked loop, which can generate a receiver clock signal and a transmitter clock signal, respectively, based at least in part on the reference clock signal. The multi-lane optical transceiver can be controlled based at least in part on i) the transmitter clock signal generated by the transmitter phase-locked loop using the reference clock signal, and ii) the receiver clock signal generated by the receiver phase-locked loop using the reference clock signal.

In at least one example, the multi-lane optical transceiver can be controlled based at least in part on i) the transmitter clock signal generated by the transmitter phase-locked loop using the reference clock signal, and ii) the receiver clock signal generated by the receiver phase-locked loop using the reference clock signal so that an average frequency error between the incoming data input into the plurality of lanes and the receiver clock signal and the transmitter clock signal is less than a threshold, such as 0.1 PPM, or stated another way, so that the average frequency error between the incoming data input and the receiver clock signal and the transmitter clock signal is substantially zero during steady-state operation, e.g., <<0.1PPM, or such as at least <0.1PPM. In addition, in executing the feedback loop, the lane status of the master lane and non-master lanes can be monitored. When the master lane is determined to have dropped or otherwise become invalid, the master lane can be dynamically switched to another valid lane. This can ensure that the coarse error and the fine error used to determine the frequency error are based on a master lane that is valid.

The multi-lane optical transceiver architectures and firmware-based feedback loops disclosed herein can provide one or more advantages, benefits, and/or technical effects. For instance, the disclosed subject matter can enable a retiming solution that allows for continuous tracking of the status of each lane and can enable switching of the master lane for PPM transfer without causing any bit errors in any of the active lanes. In addition, the disclosed subject matter can provide a retiming optical transceiver chip with only two phase-locked loops and one common phase rotator for all lanes along a transmitter path, which can minimize the chip area and power. Also, the disclosed subject matter can be implemented in generic multi-lane transceivers without any changes to the chip's hardware. In addition, the disclosed subject matter can provide a firmware-based PPM tracking loop that works robustly across multiple digital signal processing (DSP) chips. Further, the disclosed subject matter can enable an 800G electro-optical transceiver chain having an average pre-FEC BER of <1e-10. Moreover, the disclosed subject matter can be used in any previous or next-generation multi-lane transceiver modules and is agnostic to the type of modulation scheme or number of channels in the system. Also, with the firmware-based feedback loop of the present disclosure, the phase rotator of a CDR circuit can have relatively slow rotation compared to some optical transceivers, since the PPM error is "near zero". This can greatly reduce the probability of causing errors during master lane switching. In this regard, the subject matter disclosed herein can provide a technological solution for improving the performance and functionality of multi-lane optical transceivers.

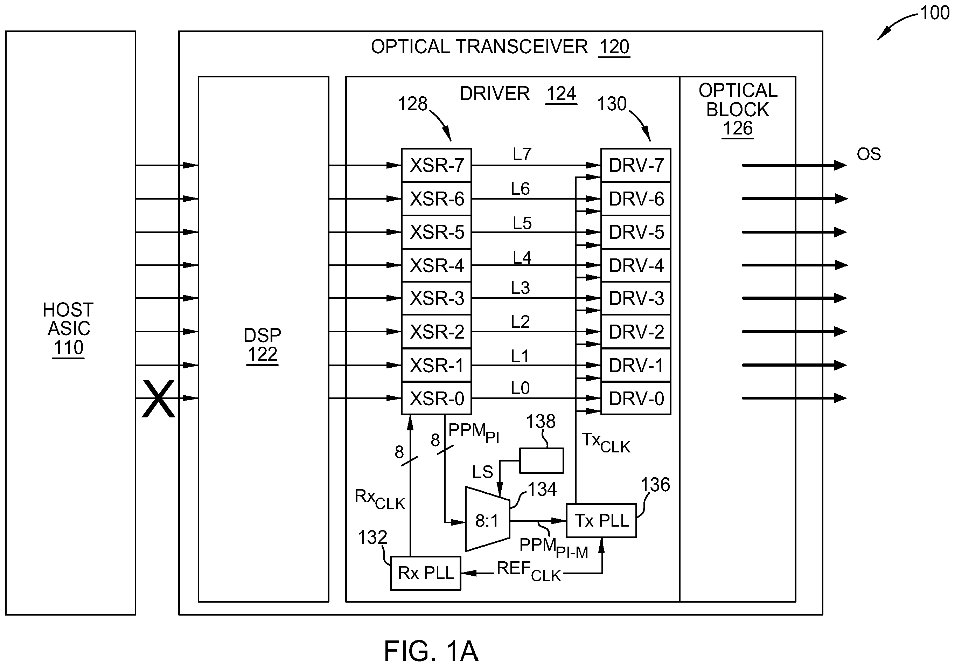

Turning now to the drawings, FIG. 1A is a schematic diagram of a transmitter path of an optical module 100. The optical module 100 includes a host application-specific integrated circuit (ASIC), or host ASIC 110, along with a multi-lane optical transceiver 120. The host ASIC 110 is electrically coupled with the multi-lane optical transceiver 120 by a plurality of lanes. In the depicted example of FIG. 1A, the optical module 100 includes eight (8) lanes on its transmitter path, including a zeroth lane L0, a first lane L1, a second lane L2, a third lane L3, a fourth lane L4, a fifth lane L5, a sixth lane L6, and a seventh lane L7. In other examples, the optical module 100 can include a different number of lanes along its transmitter path. In one or more examples, one of the lanes can be assigned as the master lane. For instance, in FIG. 1A, the zeroth lane L0 can be assigned as the master lane.

The multi-lane optical transceiver 120 includes a digital signal processor (DSP), or DSP 122, a driver 124, and an optical block 126. The DSP 122 can convert analog electrical signals received from the host ASIC 110 into digital data. This digital data can be routed to the driver 124. The driver 124 includes a plurality of receivers, which in this example are extremely short-reach receivers (XSRs), or XSRs 128. In one or more other examples, the receivers can be long reach (LR) receivers or other types of multi-lane wireline receivers. The driver 124 also includes a plurality of optical drivers 130 electrically coupled with respective ones of the XSRs 128, e.g., by way of the lanes. In the illustrated example of FIG. 1A, the driver 124 includes eight (8) XSRs (one per lane), including XSR-0 through XSR-7, as well as eight (8) optical drivers (one per lane), including DRV-0 through DRV-7.

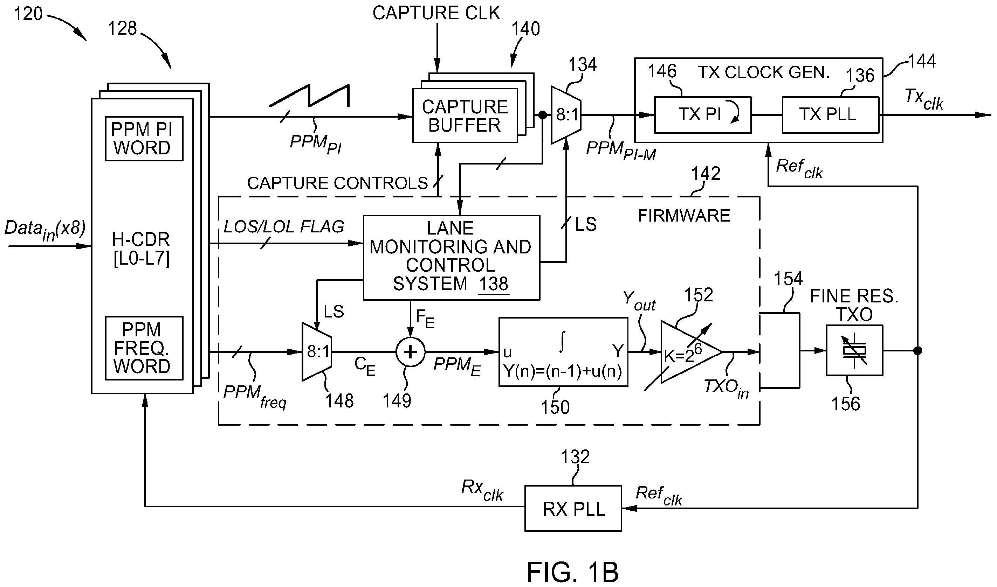

A receiver phase-locked loop (PLL), or receiver PLL 132, can input a receiver clock signal Rx_{CLK} into respective ones of the XSRs 128. The receiver clock signal Rx_{CLK} can be based at least in part on a reference clock signal Ref_{CLK} (see also FIG. 1B). Moreover, each one of the XSRs 128 can include a clock and data recovery (CDR) circuit, such as host side clock and data recovery (H-CDR) circuits. The H-CDR circuit of a given one of the XSRs 128 can be arranged to capture phase and frequency information (or parts-per-million (PPM) information) of data signals traveling along its associated lane. The phase information, or phase interpolator (PI) control word PPM_{PI}, from each lane can be input into a multiplexer 134. The multiplexer 134 can output a master lane PI control word PPM_{PI-M} (i.e., the PI control word associated with the master lane) to a transmitter PLL 136. In FIG. 1A, the zeroth lane L0 is assigned as the master lane, and thus, the master lane PI control word PPM_{PI-M} output by the multiplexer 134 is the PI control word captured from the zeroth lane L0. The transmitter PLL 136 can output a transmitter clock signal Tx_{CLK} to respective ones of the optical drivers 130 based on the master lane PI control word PPM_{PI-M} and the reference clock signal Ref_{CLK}.

The optical drivers 130 can each provide outputs to the optical block 126, or more specifically, to respective optical modulators. The optical drivers 130 can also include serializers to multiplex the data before transmission. The optical modulators can modulate optical signals OS based on the outputs received from the optical drivers 130. The optical signals OS can be carried along respective optical fibers, for example. Some examples of optical modulators include Mach-Zehnder Interferometers (MZI), Electro-Absorption Modulated Laser (EML), etc., which can be used to modulate and transmit optical signals OS over optical fibers.

In one or more examples, one or more of the lanes can drop or otherwise become invalid, including the master lane. For instance, when the master lane drops or becomes invalid, as designated by the "X" along the zeroth lane L0 in FIG. 1A, the multi-lane optical transceiver 120 may not operate optimally and/or a first-in, first-out (FIFO) buffers associated with the multi-lane optical transceiver 120 can crash or otherwise operate less than optimally. Also, the reference clock signal Ref_{CLK} can be affected when the master lane becomes invalid.

In accordance with the inventive aspects of the present disclosure, the multi-lane optical transceiver 120 can include a lane monitoring and control system 138 arranged to detect lane drops and to switch the master lane to another valid lane when the master lane drops. In one or more examples, the lane monitoring and control system 138 can be an executable program of a firmware-based feedback loop. When the master lane has dropped, the lane monitoring and control system 138 can be used to control switching of the master lane to another one of the lanes, such as to a neighbor lane. A lane switch indicator L_{S} indicating that the master lane has been switched to a new master lane can be provided to the multiplexer 134, as depicted in FIG. 1A, and used to control the PI control word output by the multiplexer 134 to the transmitter PLL 136. That is, when the master lane is switched from one lane to another, rendering a new master lane, the PI control word associated with the new master lane is output by the multiplexer 134 to the transmitter PLL 136. In this way, the lane monitoring and control system 138 can detect lane drops immediately and switch the master lane with no FIFO crash and/or no or reduced forward error correction (FEC) alignment loss. In addition, the lane switch indicator L_{S} can also be used to track the coarse error and fine error associated with the data traveling along the multi-lane optical transceiver 120, as will be explained in greater detail herein. Moreover, the lane monitoring and control system 138 can also provide proportional-integral (P-I) control, as will be provided in further detail herein.

FIG. 1B is a schematic block diagram depicting logic that can be implemented in the multi-lane optical transceiver 120 of the optical module 100 of FIG. 1A. As illustrated, the phase information of the PPM frequency error, or PI control words PPM_{PI}, from the H-CDR circuits of the XSRs 128 can be captured using a capture buffer 140. The PI control words PPM_{PI} captured by the capture buffer 140 can be passed to the lane monitoring and control system 138, which can be an executable program of firmware 142 of the multi-lane optical transceiver 120. In one or more other examples, the lane monitoring and control system 138 can be an executable software program stored on a memory device, such as a non-transitory memory device. As noted above, the lane monitoring and control system 138 is arranged to detect lane drops and switching of the master lane to another valid lane when the master lane has dropped. The lane switch indicator L_{S} indicating that the master lane has been switched to a new master lane can be provided to the multiplexer 134 as depicted in FIG. 1B. The master lane PI control word PPM_{PI-M} can be provided to a transmitter clock generator 144. The transmitter clock generator 144 includes a transmitter PI 146 and the transmitter PLL 136. The transmitter clock generator 144 can generate the transmitter clock signal Tx_{CLK}, e.g., which can be routed to respective ones of the optical drivers 130 as shown in FIG. 1A.

In addition, frequency control words PPM_{freq} captured by the H-CDR circuits of the XSRs 128 can be input into the firmware 142. The frequency control words PPM_{freq} from each lane can be input into a firmware multiplexer 148. The firmware multiplexer 148 can output a coarse error C_{E}. In at least one example, the coarse error C_{E} is equal to the frequency control word PPM_{freq} associated with the data traveling along the master lane. The coarse error C_{E} can be input into a summation block 149. Further, a fine error F_{E} can be input into the summation block 149 as well. The fine error F_{E} can be determined using P-I control based on successively captured PI control words PPM_{PI} associated with the master lane, as will be explained in greater detail herein. A frequency error PPM_{E}, which is determined based on the coarse error C_{E} and a fine error F_{E}, can be output from the summation block 149 to an accumulator 150.

The accumulator 150 can accumulate the frequency error and generate an output Yₒᵤₜ, or accumulated frequency error. A gain 152 can be applied to scale the output Yₒᵤₜ of the accumulator 150, rendering a tunable crystal oscillator input TXOᵢₙ, or scaled accumulated frequency error. The tunable crystal oscillator input TXOᵢₙ can be output from the firmware 142 by an inter-integrated circuit 154, which can route the tunable crystal oscillator input TXOᵢₙ to a tunable oscillator 156. The tunable oscillator 156 can output the reference clock signal Ref_{CLK} to the transmitter clock generator 144 and the receiver PLL 132, as illustrated in FIG. 1B. The transmitter PLL 136 of the transmitter clock generator 144 can use the reference clock signal Ref_{CLK} to generate the transmitter clock signal Tx_{CLK}, which can be routed to respective ones of the optical drivers 130 as shown in FIG. 1A. The receiver PLL 132 can use the reference clock signal Ref_{CLK} to generate the receiver clock signal Rx_{CLK}, which can be fed to the XSRs 128 as shown in FIG. 1B.

Also, a loss of signal (LOS) flag and/or loss of CDR lock (LOL) flag captured by the H-CDR circuits of the XSRs 128 can be input into the firmware 142. The lane monitoring and control system 138 can selectively read the LOS and/or LOL flags associated with the master lane, and in some instances, the LOS and/or LOL flags associated with one or more of the non-master lanes. In this way, when one or more of the lanes drop or otherwise become invalid, the lane monitoring and control system 138 can switch the master lane to another valid lane.

Accordingly, when executed by one or more processors, the firmware 142 accumulates the frequency error and drives the tunable oscillator 156 (e.g., via a serial peripheral interface (SPI)), whose output is fed as a reference clock signal Ref_{CLK} to the transmitter PLL 136 and the receiver PLL 132. The firmware-based feedback loop sets the control word of the tunable oscillator 156 such that the average frequency error between the Tx/Rx PLL clocks and the incoming data (Dataᵢₙ) received by the XSRs 128 is near-zero, e.g., <<0.1PPM. Indeed, the host ASIC 110, the DSP 122, and the driver 124 (see FIG. 1A) can all have their own oscillator sources, and consequently, there may be frequency error between them. Nevertheless, the control scheme set forth in FIG. 1B can ensure that the average frequency error between the Tx/Rx PLL clocks and the incoming data (Dataᵢₙ) received by the XSRs 128 is substantially zero, as noted above.

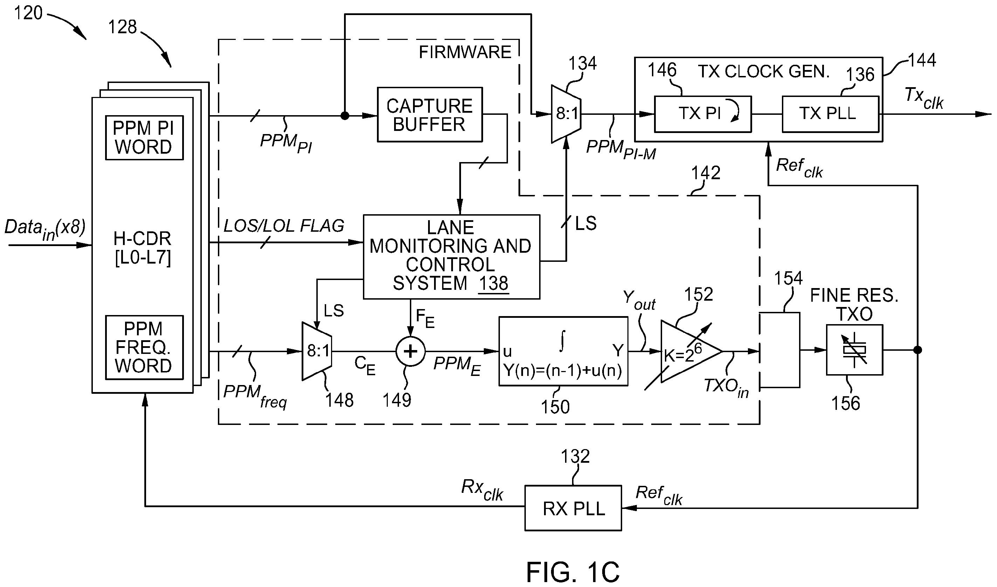

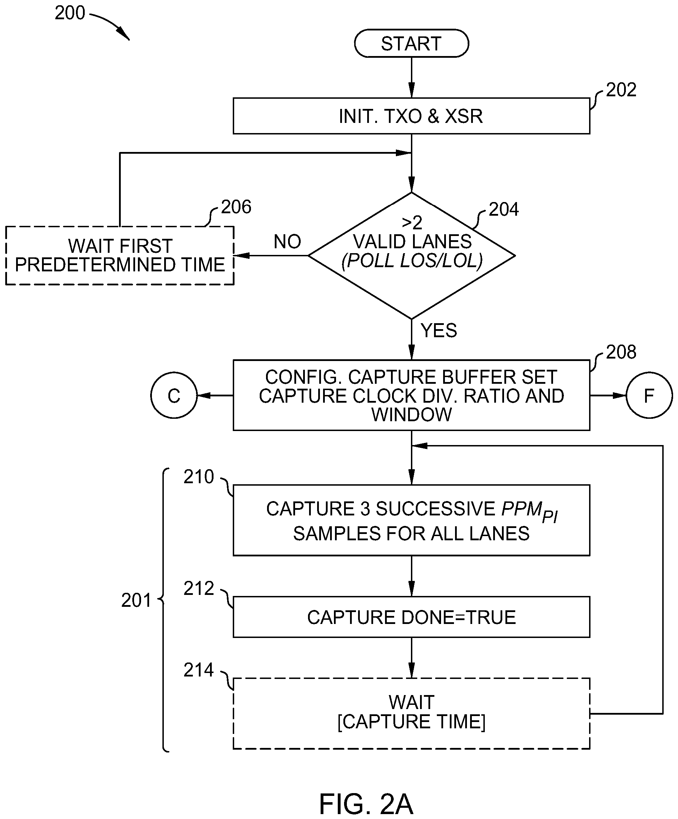

FIG. 1C is a schematic block diagram depicting logic that can be implemented in the multi-lane optical transceiver 120 of the optical module 100 of FIG. 1A. The logic illustrated in FIG. 1C is the same as the logic depicted in FIG. 1B, except as provided below. In FIG. 1C, the capture of PI control words of the data traveling along the lanes is performed by executing the firmware 142, rather than by being captured by the capture buffer 140 in FIG. 1B. Thus, the capture buffer hardware can be replaced with a firmware process. The capture process performed by executing the firmware 142 can directly sample the PPM_{PI} words for each lane every "capture time", such as every 20us. In at least one example, the capture process can correspond to the PPM_{PI} word capture loop 201 depicted in FIG. 2A.

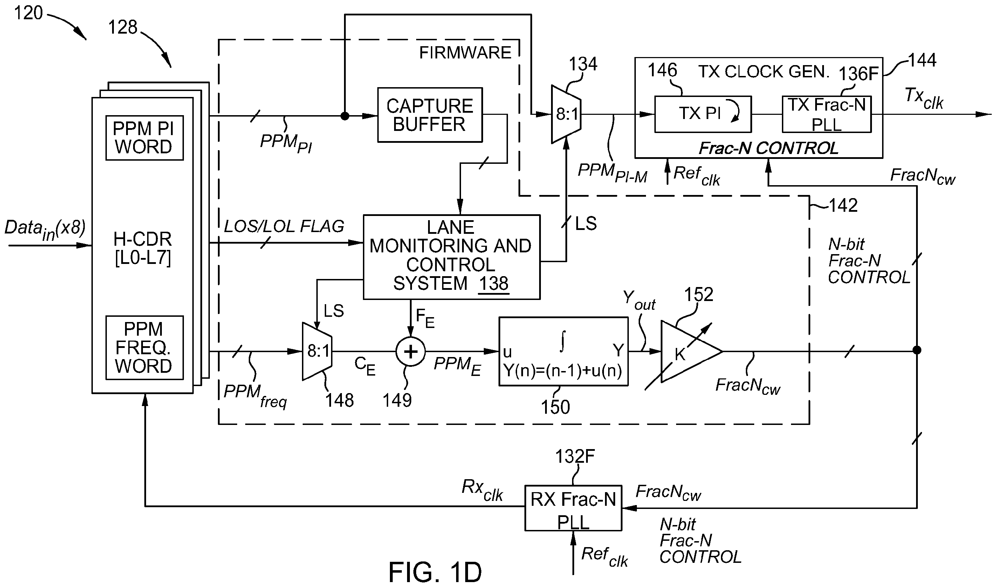

FIG. 1D is a schematic block diagram depicting logic that can be implemented in the multi-lane optical transceiver 120 of the optical module 100 of FIG. 1A. The logic illustrated in FIG. 1D is the same as the logic depicted in FIG. 1C, except as provided below.

In FIG. 1D, the logic is configured so that the firmware-based feedback loop can directly control the control word of at least one fractional-N PLL inside the chip. As shown in FIG. 1D, the receiver PLL 132 of FIGS. 1B and 1C can be replaced with a RX Frac-N PLL 132F, the transmitter PLL 136 of FIGS. 1B and 1C can be replaced with a TX Frac-N PLL 136F, and the tunable oscillator 156 of FIGS. 1B and 1C can be omitted in the logic of FIG. 1D.

In the depicted example of FIG. 1D, the gain 152 can be applied to scale the output Yₒᵤₜ of the accumulator 150, rendering a fractional control word FracN_{CW}. The fractional control word FracN_{CW}, which is generated by scaling the accumulated frequency error, can be provided to the RX Frac-N PLL 132F and to the TX Frac-N PLL 136F so that an average frequency error PPM_{E-AVG} between incoming data input into the plurality of lanes and a transmitter clock signal Tx_{CLK} output by the TX Frac-N PLL 136F and a receiver clock signal Rx_{CLK} output by the RX Frac-N PLL 132F is substantially zero during steady-state operation. The output of the firmware 142, the fractional control word FracN_{CW}, can be an N-bit control word that changes the control word of the RX Frac-N PLL 132F and the TX Frac-N PLL 136F to ensure near-zero PPM in steady state. Moreover, instead of receiving the reference clock signal Ref_{clk} as an output from the tunable oscillator 156 of FIGS. 1B and 1C, the reference clock signal Ref_{CLK} can be determined external to the firmware 142 and input into the RX Frac-N PLL 132F and the TX Frac-N PLL 136F as depicted in FIG. 1D.

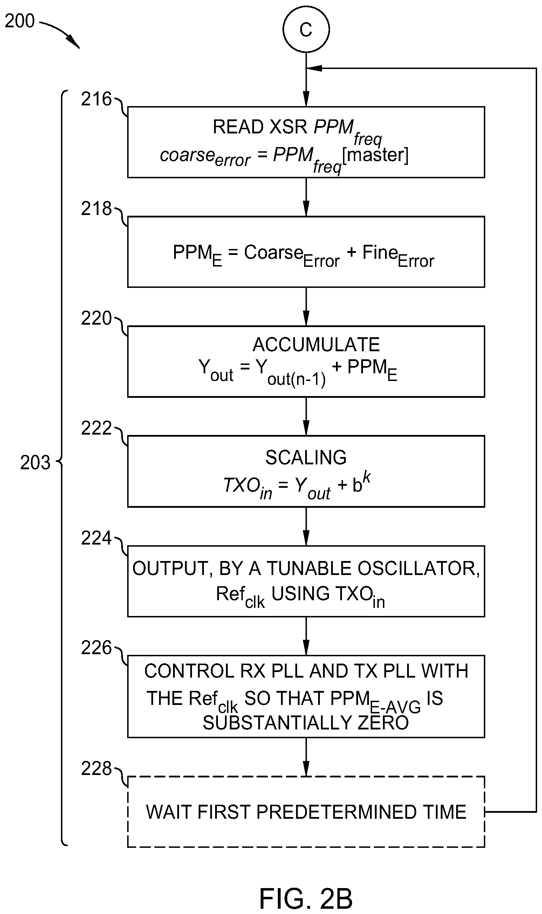

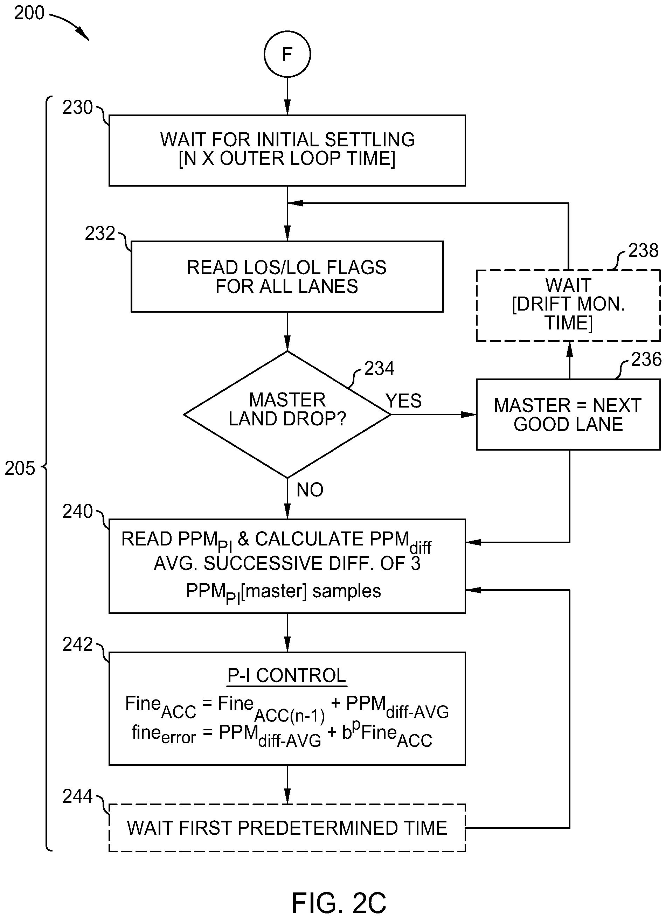

FIG. 2 is a flow diagram for a method 200 of frequency error tracking and lane monitoring for a multi-lane direct detect optical transceiver, according to one or more aspects of the present disclosure. The method 200 can be used to implement aspects of the multi-lane optical transceiver 120 of FIGS. 1A, 1B, 1C, for example. Accordingly, to provide additional context to the method 200, elements of FIGS. 1A, 1B, 1C will be referenced below.

At 202, the method 200 can include initializing a tunable crystal oscillator and a plurality of XSRs of a multi-lane optical transceiver. For instance, the tunable oscillator 156 and the XSRs 128 of the multi-lane optical transceiver 120 can be initialized.

At 204, the method 200 can include determining whether at least three of the plurality of lanes are valid. When two (2) or fewer lanes are valid as determined at 204, the method 200 can proceed to 206 to allow for a predetermined time to elapse. When greater than two lanes are valid as determined at 204, the method 200 can proceed to 208 to set capture parameters.

At 206, the method 200 can include waiting for a first predetermined time to elapse. When two (2) or fewer lanes are determined to be valid at 204, the first predetermined time is allowed to elapse, e.g., to allow time for one or more other lanes to become valid before checking the validity of the lanes once again. After the predetermined time has elapsed, the method 200 can return to 204 where it can be determined whether at least three of the plurality of lanes are valid. This loop can iterate until at least three lanes are valid as determined at 204. In at least one example, the first predetermined time can be 1 ms, 2, ms, 3 ms, etc.

At 208, the method 200 can include setting capture parameters. For instance, at 208, the capture buffer 140 can be configured and/or the capture clock division ratio and window can be set. In at least one example, the capture clock period can be set between about 10 and 30 µs, such as about 20 µs. With the capture buffer 140 configured and the capture clock division ratio and window set, the method 200 can proceed to execute three (3) loops, including a PPM_{PI} word capture loop 201 (depicted in FIG. 2A), an outer loop 203 (depicted in FIG. 2B), and an inner loop 205 (depicted in FIG. 2C). Execution of each loop will be discussed in turn.

Implementation of the PPM_{PI} word capture loop 201 will now be described.

At 210, the method 200 can include capturing successive samples of PI control words PPM_{PI} for each lane of the plurality of lanes. For instance, the PI control words PPM_{PI} can be captured for each lane of the plurality of lanes for at least three (3) successive capture periods. In at least one example, the PI control words PPM_{PI} can be captured for each lane by the capture buffer 140 of FIG. 1B. In at least one example, the PI control words PPM_{PI} can be captured for each lane by the firmware-based capture process of FIG. 1C.

At 212, the method 200 can include determining that the capturing of successive samples of PI control words PPM_{PI} for each lane of the plurality of lanes is completed. For instance, once PI control words PPM_{PI} are captured for each lane of the plurality of lanes for at least three (3) successive capture periods, the continuous capture of PI control words PPM_{PI} can be ceased, at least for a predetermined wait time.

At 214, the method 200 can include waiting for a second predetermined time to elapse. For instance, after it is determined at 212 that the capture of successive samples of PI control words PPM_{PI} for each lane of the plurality of lanes is completed, the second predetermined time can elapse before the continuous capture of PI control words PPM_{PI} is resumed. When the second predetermined time has elapsed, the method 200 can return to 210. Accordingly, the PPM_{PI} word capture loop 201 can iterate. In at least one example, the second predetermined time can be between about 200 and 300 µs, for example.

Implementation of the outer loop 203 will now be described.

After setting the capture parameters at 208, the method 200 can proceed to execute the outer loop 203 depicted in FIG. 2B in addition to the PPM_{PI} word capture loop 201 shown in FIG. 2A. The outer loop 203 can be executed in parallel with the PPM_{PI} word capture loop 201. In one or more examples, one of the lanes can be assigned as a master lane and the other lanes that are not the master lane can be designated as non-master lanes.

At 216, the method 200 can include capturing a frequency control word PPM_{freq} of the data traveling along each active lane of the plurality of lanes. For instance, the H-CDRs of the XSRs 128 can capture the frequency control word PPM_{freq} of the data traveling along their respective lanes. The captured frequency control word PPM_{freq} can be routed to the firmware multiplexer 148 of the firmware 142. The firmware multiplexer 148 can receive the frequency control words PPM_{freq} of the data traveling along the lanes and can be controlled to output a coarse error C_{E}. In at least one example, the coarse error C_{E} is equal to the frequency control word PPM_{freq} associated with the data traveling along the master lane. For instance, when the zeroth lane L0 is assigned as the master lane, the firmware multiplexer 148 outputs just the frequency control word PPM_{freq} associated with the data traveling along the zeroth lane L0. When the master lane is switched to another lane, the firmware multiplexer 148 outputs just the frequency control word PPM_{freq} associated with the data traveling along the new master lane. The coarse error C_{E}, or frequency control word PPM_{freq} associated with the data traveling along the master lane, can be output by the firmware multiplexer 148 can be routed to the summation block 149, as illustrated in FIG. 1B.

At 218, the method 200 can include determining a frequency error PPM_{E}. In at least one example, the frequency error PPM_{E} can be determined based on the coarse error C_{E} and a fine error F_{E}. The coarse error C_{E} can be determined based on the frequency information PPM_{freq} associated with the data traveling along the master lane, as described above at 216. The fine error F_{E} can be determined based on the PI control word of the data traveling along the master lane. The manner in which the fine error F_{E} can be determined will be detailed below when describing the inner loop 205.

At 220, the method 200 can include accumulating the frequency error PPM_{E}. In at least one example, accumulating the frequency error PPM_{E} includes executing the accumulator 150 to add a previously accumulated frequency error output by the accumulator in a previous iteration of the method 200 to the frequency error PPM_{E} of a current iteration of the method 200. Stated differently, the output of the accumulator Yₒᵤₜ can be calculated by adding Yₒᵤₜ₍ₙ₋₁₎ to the frequency error PPM_{E}, as depicted in FIG. 2B at 220, with n representing the current iteration of the method 200.

At 222, the method 200 can include applying a scaling factor to the accumulated frequency error Yₒᵤₜ, wherein an input provided to the external oscillator is the scaled accumulated frequency error, or tunable crystal oscillator input TXOᵢₙ. Stated another way, the scaled accumulated frequency error TXOᵢₙ provided to the external oscillator can be determined as a product of the output of the accumulator Yₒᵤₜ and a scaling factor, which is b^{k} at 222 in FIG. 2B, wherein k is a scaling exponent and b is the scaling base. In at least one example, the scaling base b can be two (2) and the scaling exponent can be six (6).

At 224, the method 200 can include outputting, by a tunable oscillator, a reference clock signal Ref_{clk} based at least in part on the accumulated frequency error. For instance, the scaled accumulated frequency error, or tunable crystal oscillator input TXOᵢₙ, provided to the tunable oscillator 156 can dynamically tune or control the tunable oscillator 156 to output the reference clock signal Ref_{clk} accordingly. The reference clock signal Ref_{clk} can be provided to the receiver PLL 132 and to the transmitter PLL 136.

At 226, the method 200 can include controlling the optical transceiver based at least in part on i) a transmitter clock signal Tx_{clk} generated by the transmitter PLL using the reference clock signal Ref_{clk}, and ii) a receiver clock signal Rx_{clk} generated by the receiver PLL using the reference clock signal Ref_{clk}. In one or more examples, the optical transceiver can be controlled based at least in part on i) the transmitter clock signal generated by the transmitter phase-locked loop using the reference clock signal, and ii) the receiver clock signal generated by the receiver phase-locked loop using the reference clock signal so that an average frequency error PPM_{E-AVG} between incoming data input into the plurality of lanes and the receiver clock signal Rx_{clk} and the transmitter clock signal Tx_{clk} is less than a threshold. In at least one example, the threshold is less than 0.1 parts-per-million. In this regard, in at least one or more examples, the average frequency error PPM_{E}. _{AVG} between the incoming data input into the plurality of lanes and the receiver clock signal Rx_{clk} and the transmitter clock signal Tx_{clk} can be substantially zero during steady-state operation. The receiver clock signal Rx_{clk} can be fed to the receivers (e.g., the XSRs 128) and the transmitter clock signal Tx_{clk} can be fed to the serializers inside the optical drivers 130, e.g., as shown in FIG. 1A.

At 228, the method 200 can include waiting for the first predetermined time to elapse. For instance, after the accumulated frequency error TXOᵢₙ is provided to the external oscillator for tuning and determination of the reference clock signal Ref_{clk}, the first predetermined time can elapse before the outer loop 203 is iterated. When the first predetermined time has elapsed, the method 200 can return to 216. Accordingly, the outer loop 203 can iterate, e.g., so that the external oscillator can be dynamically tuned according to the phase and frequency information associated with the master lane. Dynamically tuning the external oscillator in this manner can in turn cause the external oscillator to dynamically generate the reference clock signal Ref_{clk} that ultimately enables the average frequency error PPM_{E-AVG} between the incoming data input into the plurality of lanes at the receiver side and a transmitter clock signal Tx_{clk} output by the transmitter PLL and a receiver clock signal Rx_{clk} output by the receiver PLL to be substantially zero during steady-state operation of the multi-lane optical transceiver 120. In at least one example, the first predetermined time can be 1 ms, 2, ms, 3 ms, etc., as noted at 206.

Implementation of the inner loop 205 will now be described.

After setting the capture parameters at 208, the method 200 can proceed to execute the inner loop 205 depicted in FIG. 2C in addition to executing the PPM_{PI} word capture loop 201 shown in FIG. 2A and the outer loop 203 illustrated in FIG. 2B. The inner loop 205 can be executed in parallel with the PPM_{PI} word capture loop 201 and/or the outer loop 203. As will be detailed below, the inner loop 205 can be executed to monitor the validity of the master lane, and when the master lane drops or becomes invalid, the inner loop 205 can be executed to dynamically switch the master lane to another valid lane. In addition, execution of the inner loop 205 can be used to determine the fine error F_{E} used to determine the frequency error PPM_{E} at 218.

At 230, the method 200 can include waiting for an initial settling time to elapse. In one or more examples, the initial settling time can correspond to predetermined outer loop time multiplied by *N,* wherein N is a number of lanes of the plurality of lanes.

At 232, the method 200 can include reading a loss of signal (LOS) and/or loss of CDR lock flag (LOL) for each active lane of the plurality of lanes. For instance, as shown in FIG. 1B, the LOS and/or LOL flag can be provided to the firmware 142 by the H-CDRs of the XSRs 128. The LOS/LOL flag can be generated using dedicated analog or digital hardware inside the XSRs 128.

At 234, the method 200 can include determining whether the master lane has dropped based on the LOS and/or LOL readings. For instance, as shown in FIG. 1B, the LOS/LOL flags can be input into the lane monitoring and control system 138, and the lane monitoring and control system 138 can be executed to determine whether the master lane has dropped or otherwise become invalid. In at least one example, a LOS flag can indicate that the master lane is invalid, e.g., due to a loss of signal. In at least one example, a LOL flag can indicate that the master lane is invalid, e.g., due to the lock status of the CDR associated with the master lane.

In one or more examples, in addition to determining whether the master lane is valid, at 234, the method 200 can include determining whether any of the non-master lanes are invalid based on the LOS and/or LOL flag readings. For instance, upon determining that the master lane is invalid, the LOS and/or LOL flags can be read for at least one non-master lane, such as a neighbor lane. In this way, it can be ensured that the master lane is switched to a valid lane at 236. When the neighbor lane or other non-master lane is determined to be invalid, such invalid non-master lanes can be removed from consideration for being the new master lane.

At 236, the method 200 can include, in response to determining that the master lane has dropped based on the LOS and/or LOL readings, switching the master lane to another one of the plurality of lanes. The master lane can be switched to a next valid lane, for example. In at least one example, when the master lane is switched from one lane to another, a lane switch indicator L_{S} can be routed to the multiplexer 134 to indicate the new master lane. As noted above, the multiplexer 134 is arranged to output the PI control word of the master lane PPM_{PI-M}. Accordingly, when the master lane is switched from one lane to another, rendering a new master lane, the PI control word output by the multiplexer 134 switches from outputting the PI control word of the former master lane to the new master lane. In this way, the PI control word of the new master lane PPM_{PI-M} can be fed to the transmitter PLL 136 of the transmitter clock generator 144 and used to generate a transmitter clock signal Tx_{clk}, as depicted in FIG. 1B. Thus, the lane switch indicator L_{S} can be used to control which lane's PI control word that the multiplexer 134 outputs to the transmitter clock generator 144.

In addition, in one or more examples, the lane switch indicator L_{S} can be routed to the firmware multiplexer 148 to indicate the new master lane, e.g., to control which lane's frequency control word PPM_{freq} is output to the summation block 149. As noted previously, the coarse error C_{E} can be or equate to the frequency control word PPM_{freq} associated with the master lane.

At 238, the method 200 can include waiting for a drift monitoring time to elapse. In one or more examples, the drift monitoring time can be between about 200 and 300 µs. Once the drift monitoring time has elapsed, the method 200 can return to 232, where the LOS/LOL flags can be read once again.

At 240, the method 200 can include, in response to determining that the master lane has not dropped based on the LOS and/or LOL readings as determined at 234 or after switching the master lane to another valid lane at 236, reading the PI control words PPM_{PI} of the data traveling along the master lane (or the new master lane) for a predetermined number of successive capture cycles. The PI control words PPM_{PI} that are read at 240 can be captured using the PPM_{PI} word capture loop 201. In at least one example, the predetermined number of successive capture cycles can be set at three (3) successive capture cycles. In one or more other examples, however, the predetermined number of successive capture cycles can be set at more or less than three (3) successive capture cycles.

Once the PI control words PPM_{PI} for the master lane are read, at 240, the method 200 can further include determining a difference PPM_{diff} between the PI control words PPM_{PI} of the data traveling along the master lane between successive readings. Also, at 240, the method 200 can include determining an average successive difference PPM_{diff-AVG} based on the differences PPM_{diff}. For instance, the difference PPM_{diff} between the PI control word PPM_{PI} of a first reading and the PI control word PPM_{PI} of a second reading can be determined, and the difference PPM_{diff} between the PI control word PPM_{PI} of the second reading and the PI control word PPM_{PI} of a third reading can be determined. An average of these two differences PPM_{diff} can be determined as the average successive difference PPM_{diff-AVG}.

At 242, the method 200 can include implementing proportional and integral control to determine the fine error F_{E} based on the average successive difference PPM_{diff-AVG}. In at least one example, the fine error F_{E} can be determined as a sum of the average successive difference PPM_{diff-AVG} and a product of a fine accumulator gain b^{p} and an accumulated fine error F_{E-ACC}. For the fine accumulator gain b^{p}, the b is a gain base and the p is a division factor. In at least one example, the gain base can be two (2) and the division factor can be -8. In one or more examples, the accumulated fine error F_{E-ACC} can be determined by adding a previously accumulated fine error F_{E-ACC(n-1)} to the average successive difference PPM_{diff-AVG}, as shown at 242 in FIG. 2C.

The fine error F_{E} determined at 242 can be used at 218 to determine a frequency error PPM_{E}. The fine error FE can be routed to the summation block 149, as illustrated in FIG. 1B. Accordingly, the frequency error PPM_{E} can be determined based on the coarse error C_{E} and the fine error F_{E}. In at least one example, the coarse error C_{E} and the fine error F_{E} can be added together at the summation block to determine the frequency error PPM_{E}.

At 244, the method 200 can include waiting for the first predetermined time to elapse. After the first predetermined time has elapsed, the method 200 can return to 240. In at least one example, the first predetermined time can be 1 ms, 2, ms, 3 ms, etc., as noted at 206 and at 228.

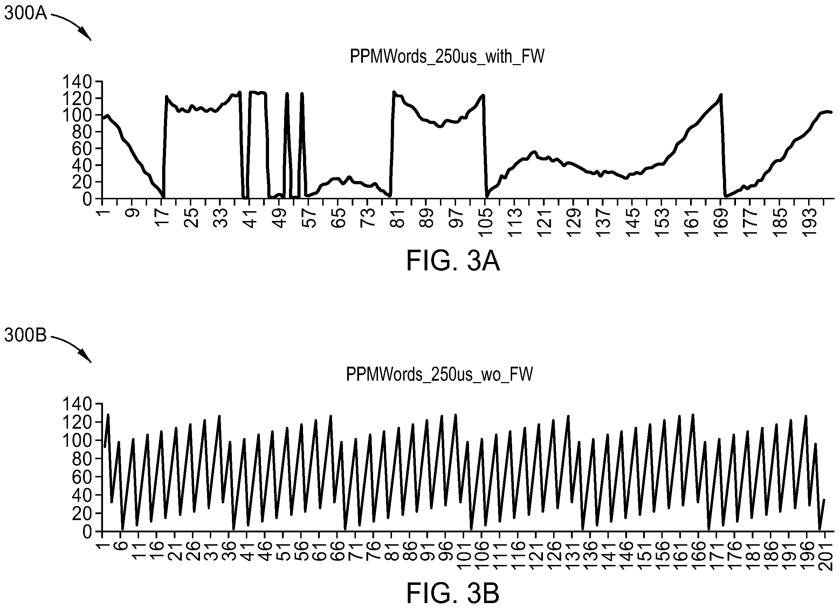

With reference now to FIGS 3A and 3B, FIG. 3A shows a graph 300A depicting phase error accumulation in an optical transceiver implementing the method 200 of FIGS. 2A, 2B, 2C, and FIG. 3B shows a graph depicting phase error accumulation in the optical transceiver without implementing the method 200. In graphs 300A and 300B, the PI control words of the data was sampled every 250 µs.

As shown in the graph 300A of FIG. 3A, the CDR's phase interpolator has relatively slow rotation (compared to its rotation in the graph 300B of FIG. 3B), since the PPM error is "near zero". Advantageously, the relatively slow rotation can greatly reduce the probability of causing errors during master lane switching, namely because fewer cycles of data are missed. The phase interpolator's rotation rate can slow down to as low as 1 LSB/250µs, corresponding to 2.3mPPM. In one or more examples, 1 LSB can correspond to the frequency control resolution of the tunable oscillator 156 (FIGS. 1B, 1C) or the frac-N PLLs 132F, 136F (FIG. 1D). In at least one example, the maximum delay for lane switching is 250µs (i.e., the firmware update rate in this example), and the PI control words rotate at a maximum rate of 1 LSB/250µs. Thus, for this example, the maximum phase interpolator code jump while lane switching is bounded within ±64, and the maximum phase error accumulated is π at Baudrate/4 Hz for a 7 bit PI control word, corresponding to only 2 UI error accumulation. With a FIFO depth of 8, operating at Baudrate/64, the jump is 1/32nd of the FIFO clock period, which is negligible and does not cause any shift in the FIFO read pointer.

In the graph 300B of FIG. 3B, in contrast, the PI control words change relatively rapidly (compared to their relatively slow change in the graph 300A in FIG. 3A), thereby increasing the probability of error while master lane switching. Accordingly, without execution of the method 200, the phase interpolator can rotate as fast as 1 LSB/2.4ns, corresponding to 246PPM.

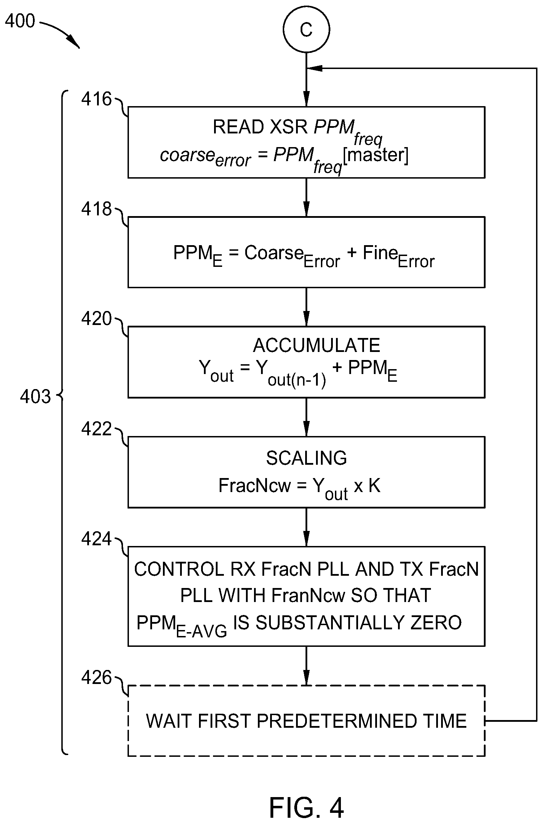

FIG. 4 is a flow diagram for a method 400 of frequency error tracking and lane monitoring for a multi-lane direct detect optical transceiver, according to one or more aspects of the present disclosure. The method 400 can be used to implement aspects of the multi-lane optical transceiver 120 of FIGS. 1A and 1D, for example. Accordingly, to provide additional context to the method 400, elements of FIGS. 1A and 1D will be referenced below.

The method 400 provides an alternative manner in which the outer loop 203 of the method 200 depicted in FIG. 2B can be implemented. Accordingly, the method 400 can be used in conjunction with the method 200. Thus, in at least one example, the method 200 can be implemented, but the outer loop 203 of FIG. 2B can be replaced with outer loop 403 of FIG. 4.

At 416, the method 400 can include capturing a frequency control word PPM_{freq} of the data traveling along each active lane of the plurality of lanes. For instance, the H-CDRs of the XSRs 128 can capture the frequency control word PPM_{freq} of the data traveling along their respective lanes. The captured frequency control word PPM_{freq} can be routed to the firmware multiplexer 148 of the firmware 142. The firmware multiplexer 148 can receive the frequency control words PPM_{freq} of the data traveling along the lanes and can be controlled to output a coarse error C_{E}. In at least one example, the coarse error C_{E} is equal to the frequency control word PPM_{freq} associated with the data traveling along the master lane.

At 418, the method 400 can include determining a frequency error PPM_{E}. In one or more examples, the frequency error PPM_{E} can be determined using a coarse error C_{E} determined based on the frequency control word PPM_{freq} associated with the data traveling along the master lane and a fine error F_{E} determined based on the PI control word PPM_{PI} of the data traveling along the master lane. The PI control word PPM_{PI} can be captured, e.g., according to the PPM_{PI} word capture loop 201 depicted in FIG. 2A. The fine error F_{E} can be determined according to the inner loop 205 depicted in FIG. 2C.

At 420, the method 400 can include accumulating the frequency error PPM_{E}. In at least one example, accumulating the frequency error PPM_{E} includes executing the accumulator 150 to add a previously accumulated frequency error output by the accumulator in a previous iteration of the method 400 to the frequency error PPM_{E} of a current iteration of the method 400. Stated differently, the output of the accumulator Yₒᵤₜ can be calculated by adding Yₒᵤₜ₍ₙ₋₁₎ to the frequency error PPM_{E}, as depicted in FIG. 4 at 420, with n representing the current iteration of the method 400.

At 422, the method 400 can include applying a scaling factor to the accumulated frequency error Yₒᵤₜ. For instance, the gain 152 depicted in FIG. 1D can be applied to the accumulated frequency error Yₒᵤₜ. In one or more examples, the gain 152, represented as K in FIG. 1D, can be six (6). In other examples, the gain K can be more or less than six (6). The gain 152 can be applied to scale the output Yₒᵤₜ of the accumulator 150, rendering a fractional control word FracN_{CW}. Accordingly, the fractional control word FracN_{CW} can be generated based at least in part on the frequency error PPM_{E}, such as on the accumulated frequency error Yₒᵤₜ. The fractional control word FracN_{CW} can be provided to the RX Frac-N PLL 132F and to the TX Frac-N PLL 136F, as depicted in FIG. 1D.

At 424, the method 400 can include controlling the optical transceiver based at least in part on i) a transmitter clock signal generated by the fractional transmitter phase-locked loop using the fractional control word, and ii) a receiver clock signal generated by the fractional receiver phase-locked loop using the fractional control word. For instance, in one or more examples, the multi-lane optical transceiver 120 can be controlled so that an average frequency error PPM_{E-AVG} between incoming data (denoted as Dataᵢₙ in FIG. 1D) input into the plurality of lanes and a transmitter clock signal Tx_{CLK} output by the TX Frac-N PLL 136F and a receiver clock signal Rx_{CLK} output by the RX Frac-N PLL 132F is less than a threshold. In at least one example, the threshold is less than 0.1 parts-per-million. Stated another way, in at least one example, the multi-lane optical transceiver 120 can be controlled so that the average frequency error PPM_{E-AVG} is substantially zero during steady-state operation. The fractional control word FracN_{CW} can be an N-bit control word that changes the control word of the RX Frac-N PLL 132F and the TX Frac-N PLL 136F to ensure near-zero PPM in steady state.

At 426, the method 400 can include waiting for the first predetermined time to elapse. For instance, after the fractional control word FracN_{CW} is provided to the RX Frac-N PLL 132F and to the TX Frac-N PLL 136F, the first predetermined time can elapse before the outer loop 403 is iterated. When the first predetermined time has elapsed, the method 400 can return to 416. Accordingly, the outer loop 403 can iterate, e.g., so that the fractional control word FracN_{CW} can be dynamically provided to the RX Frac-N PLL 132F and to the TX Frac-N PLL 136F according to the phase and frequency information associated with the master lane. In at least one example, the first predetermined time can be 1 ms, 2, ms, 3 ms, etc.

In implementing the outer loop 403 of FIG. 4 in conjunction with the method 200 (with the outer loop 203 of FIG. 2B being replaced with the outer loop 403), the relatively slow rotation of the CDR's phase interpolator can be achieved, much like as described above with respect to the graphs of FIGS. 3A and 3B.

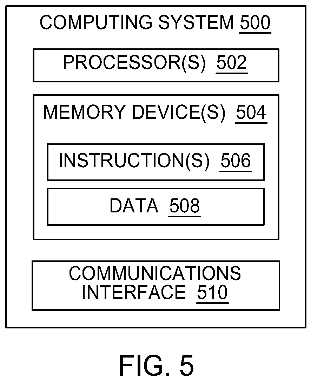

FIG. 5 is a block diagram of the computing system 500 that can be implemented with the optical module 100 and/or any of the multi-lane optical transceivers disclosed herein.

As shown in FIG. 5, the computing system 500 can include one or more processor(s) 502 and one or more memory device(s) 504. The one or more processor(s) 502 can include any suitable processing device, such as a microprocessor, microcontroller, integrated circuit, logic device, or other suitable processing device. The one or more memory device(s) 504 can include one or more computer-readable medium, including, but not limited to, non-transitory computer-readable medium, RAM, ROM, hard drives, flash drives, and other memory devices.

The one or more memory device(s) 504 can store information accessible by the one or more processor(s) 502, including computer-readable instructions 506 or computer-readable program code that can be executed by the one or more processor(s) 502. The instructions 506 can be any set of instructions or program that, when executed by the one or more processor(s) 502, cause the one or more processor(s) 502 to perform operations. The instructions 506 can be software written in any suitable programming language or can be implemented in hardware as firmware. In at least one example, the instructions 506 can include the lane monitoring and control system 138 (FIGS. 1A, 1B, 1C, 1D).

The memory device(s) 504 can further store data 508 that can be accessed by the processor(s) 502. For example, the data 508 can include any of the data noted herein. The data 508 can include one or more table(s), function(s), algorithm(s), model(s), equation(s), libraries, etc.

The computing system 500 can also include a communication interface 510 used to communicate, for example, with the other components of the optical module 100 (FIG. 1A). The communication interface 510 can include any suitable components for interfacing with one or more network(s), including for example, transmitters, receivers, ports, controllers, antennas, or other suitable components.

In the current disclosure, reference is made to various embodiments. However, the scope of the present disclosure is not limited to specific described embodiments. Instead, any combination of the described features and elements, whether related to different embodiments or not, is contemplated to implement and practice contemplated embodiments. Additionally, when elements of the embodiments are described in the form of "at least one of A and B," or "at least one of A or B," it will be understood that embodiments including element A exclusively, including element B exclusively, and including element A and B are each contemplated. Furthermore, although some embodiments disclosed herein may achieve advantages over other possible solutions or over the prior art, whether or not a particular advantage is achieved by a given embodiment is not limiting of the scope of the present disclosure. Thus, the aspects, features, embodiments and advantages disclosed herein are merely illustrative and are not considered elements or limitations of the appended claims except where explicitly recited in a claim(s).

As will be appreciated by one skilled in the art, the embodiments disclosed herein may be embodied as a system, method or computer program product. Accordingly, embodiments may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, embodiments may take the form of a computer program product embodied in one or more computer readable medium(s) having computer readable program code embodied thereon. In one example, there is provided a computer readable medium carrying instructions which, when executed by one or more processors, cause any of the methods described herein to be carried out.

Program code embodied on a computer readable medium may be transmitted using any appropriate medium, including but not limited to wireless, wireline, optical fiber cable, RF, etc., or any suitable combination of the foregoing.

Computer program code for carrying out operations for embodiments of the present disclosure may be written in any combination of one or more programming languages, including an object oriented programming language such as Java, Smalltalk, C++ or the like and conventional procedural programming languages, such as the "C" programming language or similar programming languages. The program code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present disclosure are described herein with reference to flowchart illustrations and/or block diagrams of methods, apparatuses (systems), and computer program products according to embodiments presented in this disclosure. It will be understood that each block of the flowchart illustrations and/or block diagrams, and combinations of blocks in the flowchart illustrations and/or block diagrams, can be implemented by computer program instructions. These computer program instructions may be provided to a processor of a general purpose computer, special purpose computer, or other programmable data processing apparatus to produce a machine, such that the instructions, which execute via the processor of the computer or other programmable data processing apparatus, create means for implementing the functions/acts specified in the block(s) of the flowchart illustrations and/or block diagrams.

These computer program instructions may also be stored in a computer readable medium that can direct a computer, other programmable data processing apparatus, or other device to function in a particular manner, such that the instructions stored in the computer readable medium produce an article of manufacture including instructions which implement the function/act specified in the block(s) of the flowchart illustrations and/or block diagrams.

The computer program instructions may also be loaded onto a computer, other programmable data processing apparatus, or other device to cause a series of operational steps to be performed on the computer, other programmable apparatus or other device to produce a computer implemented process such that the instructions which execute on the computer, other programmable data processing apparatus, or other device provide processes for implementing the functions/acts specified in the block(s) of the flowchart illustrations and/or block diagrams.

The flowchart illustrations and block diagrams in the Figures illustrate the architecture, functionality, and operation of possible implementations of systems, methods, and computer program products according to various embodiments. In this regard, each block in the flowchart illustrations or block diagrams may represent a module, segment, or portion of code, which comprises one or more executable instructions for implementing the specified logical function(s). It should also be noted that, in some alternative implementations, the functions noted in the block may occur out of the order noted in the Figures. For example, two blocks shown in succession may, in fact, be executed substantially concurrently, or the blocks may sometimes be executed in the reverse order, depending upon the functionality involved. It will also be noted that each block of the block diagrams and/or flowchart illustrations, and combinations of blocks in the block diagrams and/or flowchart illustrations, can be implemented by special purpose hardware-based systems that perform the specified functions or acts, or combinations of special purpose hardware and computer instructions.

In view of the foregoing, the scope of the present disclosure is determined by the claims that follow.

## Claims

1. A method, comprising:
capturing phase interpolator (PI) control words and frequency control words recovered by clock-and-data recovery circuits from data traveling along each of a plurality of lanes of an optical transceiver, with one of the plurality of lanes being assigned as a master lane;
determining a frequency error using a coarse error determined based on the frequency control word traveling along the master lane and a fine error determined based on the PI control word traveling along the master lane;
outputting, by a tunable oscillator, a reference clock signal based at least in part on the frequency error; and
controlling the optical transceiver based at least in part on i) a transmitter clock signal generated by a transmitter phase-locked loop using the reference clock signal, and ii) a receiver clock signal generated by a receiver phase-locked loop using the reference clock signal.

2. The method of claim 1, wherein the optical transceiver is controlled based at least in part on i) the transmitter clock signal generated by the transmitter phase-locked loop using the reference clock signal, and ii) the receiver clock signal generated by the receiver phase-locked loop using the reference clock signal so that an average frequency error between incoming data input into the plurality of lanes and the receiver clock signal and the transmitter clock signal is less than a threshold, optionally wherein the threshold is less than 0.1 parts-per-million.

3. The method of any preceding claim, wherein the receiver clock signal is fed to receivers of the optical transceiver and the transmitter clock signal is fed to optical drivers of the optical transceiver, wherein the receivers and the optical drivers are electrically coupled with one another by the plurality of lanes.

4. The method of any preceding claim, further comprising:
reading a loss of signal (LOS) flag, a loss of clock and data recovery (CDR) lock (LOL) flag, or both, for each lane of the plurality of lanes; and
determining whether the master lane is invalid based on the LOS flag, the LOL flag, or both.

5. The method of claim 4, further comprising:
in response to determining that the master lane is invalid, switching the master lane to another one of the plurality of lanes, rendering a new master lane.

6. The method of claim 5, further comprising:
routing a lane switch indicator to a multiplexer arranged to produce an output that is fed to the transmitter phase-locked loop, wherein the lane switch indicator indicates which of the plurality of lanes is the new master lane, and wherein the lane switch indicator causes the multiplexer to output the **PI** control word of the new master lane to the transmitter phase-locked loop.

7. The method of claim 5 or claim 6, wherein the coarse error is output by a firmware multiplexer, wherein the firmware multiplexer is controllable to output the frequency control word associated with the data traveling along the master lane, and wherein the method further comprises:
routing a lane switch indicator to the firmware multiplexer, wherein the lane switch indicator indicates which of the plurality of lanes is the new master lane,
wherein the lane switch indicator causes the firmware multiplexer to output the frequency control word of the new master lane.

8. The method of claim 4, further comprising:
in response to determining that the master lane is valid based on the LOS flag, the LOL flag, or both, or after switching the master lane to another lane of the plurality of lanes, in response to determining that the master lane is invalid based on the LOS flag, the LOL flag, or both, reading the PI control word traveling along the master lane for a predetermined number of successive capture cycles;
determining a difference between the PI control words traveling along the master lane between successive readings of the predetermined number of successive capture cycles;
determining an average successive difference based on the differences; and
implementing proportional and integral control to determine the fine error based on the average successive difference.

9. The method of any preceding claim, further comprising:
accumulating the frequency error; and
applying a scaling factor to the accumulated frequency error, wherein an input provided to the tunable oscillator is the scaled accumulated frequency error, optionally wherein accumulating the frequency error comprises executing an accumulator to add a previously accumulated frequency error output by the accumulator in a previous iteration of the method to the frequency error of a current iteration of the method.

10. The method of any preceding claim, wherein at least one of:
A. the PI control words traveling along each lane of the plurality of lanes is captured by a capture buffer;
B. the PI control words traveling along each lane of the plurality of lanes is captured by firmware on a processor of the optical transceiver; and/or
C. the PI control words rotate at a maximum rate of 1 LSB/250 microseconds.

11. An optical transceiver, comprising:
a plurality of receivers each having a clock and data recovery (CDR) circuit;
a plurality of optical drivers coupled with the receivers via respective ones of a plurality of lanes;
a receiver phase-locked loop;
a transmitter phase-locked loop;
a tunable oscillator; and
a processor arranged to execute firmware to perform an operation, the operation comprising:
receiving phase interpolator (PI) control words recovered by the CDR circuits from data traveling along each lane of the plurality of lanes, with one of the plurality of lanes being assigned as a master lane;
capturing frequency control words recovered by the CDR circuits from the data traveling along each lane of the plurality of lanes; and
determining a frequency error using a coarse error determined based on the frequency control word traveling along the master lane and a fine error determined based on the PI control word traveling along the master lane,
wherein the tunable oscillator is arranged to output a reference clock signal based at least in part on the frequency error, and wherein the optical transceiver is controllable based at least in part on i) a transmitter clock signal generated by a transmitter phase-locked loop using the reference clock signal, and ii) a receiver clock signal generated by a receiver phase-locked loop using the reference clock signal.

12. The optical transceiver of claim 11, wherein the operation further comprises the method of any of claims 2 to 10.

13. An optical transceiver, comprising:
a plurality of receivers each having a clock and data recovery (CDR) circuit;
a plurality of optical drivers coupled with the receivers via respective ones of a plurality of lanes;
a fractional receiver phase-locked loop;
a fractional transmitter phase-locked loop; and
a processor arranged to execute firmware to perform an operation, the operation comprising:
receiving phase interpolator (PI) control words recovered by the CDR circuits from data traveling along each of the plurality of lanes, with one of the plurality of lanes being assigned as a master lane;
capturing frequency control words recovered by the CDR circuits from the data traveling along each of the plurality of lanes;
determining a frequency error using a coarse error determined based on the frequency control word traveling along the master lane and a fine error determined based on the PI control word traveling along the master lane; and
generating a fractional control word based at least in part on the frequency error,
wherein the optical transceiver is controllable based at least in part on i) a transmitter clock signal generated by the fractional transmitter phase-locked loop using the fractional control word, and ii) a receiver clock signal generated by the fractional receiver phase-locked loop using the fractional control word.

14. A method, comprising:
capturing phase interpolator (PI) control words recovered by clock and data recovery (CDR) circuits from data traveling along each of a plurality of lanes of an optical transceiver, with one of the plurality of lanes being assigned as a master lane;
capturing frequency control words recovered by the CDR circuits from the data traveling along each of the plurality of lanes;
determining a frequency error using a coarse error determined based on the frequency control word traveling along the master lane and a fine error determined based on the PI control word traveling along the master lane; and
generating a fractional control word based at least in part on the frequency error; and
controlling the optical transceiver based at least in part on i) a transmitter clock signal generated by the fractional transmitter phase-locked loop using the fractional control word, and ii) a receiver clock signal generated by the fractional receiver phase-locked loop using the fractional control word.

15. One or more computer readable media comprising instructions that, when executed by one or more processors, cause the method of any of claims 1 to 10 and/or 14 to be carried out.
